# FASCICULE DE BREVET EUROPEEN

(11) **EP 3 614 817 B1**
(45) Date de publication et mention de la délivrance du brevet: **22.05.2024**
(21) Numéro de dépôt: 19186991.6
(22) Date de dépôt: 18.07.2019
(51) Int. Cl.: H05K 7/14, H05K 1/02

(54) **ENSEMBLE ÉLECTRIQUE**
ELEKTRISCHE EINHEIT
ELECTRICAL ASSEMBLY

(30) Priorité: 13.08.2018 FR 1857466
(43) Date de publication de la demande: 26.02.2020
(73) Titulaire: Valeo eAutomotive France SAS, 95800 Cergy (FR)
(72) Inventeur: PARIGOT, Baptiste, 78290 CROISSY-SUR-SEINE (FR); MOCERI, Alwin, 78700 CONFLANS SAINTE-HONORINE (FR)
(74) Mandataire: Valeo Powertrain Systems

(56) Documents cités:
- EP-A1- 1 376 839
- EP-A1- 3 240 157
- EP-A2- 0 590 643
- JP-A- 2013 235 757
- US-A- 5 263 247

## Description

### DOMAINE TECHNIQUE ET OBJET DE L'INVENTION

La présente invention se rapporte au domaine des équipements électriques, notamment pour véhicules électriques ou hybrides et concerne plus particulièrement un ensemble électrique comprenant au moins une pièce de conduction électrique pour connecter une carte électronique.

L'invention vise notamment à acheminer une énergie électrique sur une carte électronique depuis une barre de connexion électrique.

### ETAT DE LA TECHNIQUE

Comme cela est connu, un véhicule automobile électrique ou hybride comprend un système de motorisation électrique alimenté par une batterie d'alimentation haute tension via un réseau électrique embarqué haute tension et une pluralité d'équipements électriques auxiliaires alimentés par une batterie d'alimentation basse tension via un réseau électrique embarqué basse tension.

La batterie d'alimentation haute tension assure une fonction d'alimentation en énergie du système de motorisation électrique permettant la propulsion du véhicule. Plus précisément, afin de commander le moteur électrique entraînant les roues du véhicule, il est connu d'utiliser un onduleur permettant de convertir le courant continu fourni par la batterie d'alimentation haute tension en un ou plusieurs courants de commande alternatifs, par exemple sinusoïdaux. Dans un équipement électrique tel qu'un onduleur, pour en simplifier la fabrication par rapport à la conformation et à l'encombrement des composants, il peut être préférable d'utiliser plusieurs barres de connexion électriques connectées entre elles pour acheminer le courant d'un point à un autre, plutôt qu'une seule barre de conduction électrique. Typiquement, une première barre de connexion électrique est connectée par une première extrémité à un connecteur connecté à la batterie d'alimentation haute tension, et à une deuxième barre de connexion électrique par une deuxième extrémité. La deuxième barre de connexion électrique achemine le courant vers un composant électrique de l'équipement. Pour filtrer le courant délivré par la batterie, l'équipement électrique comprend une carte électronique réalisant le filtrage du courant. Il est nécessaire d'alimenter la carte électronique pour qu'elle mette en oeuvre sa fonction de filtrage.

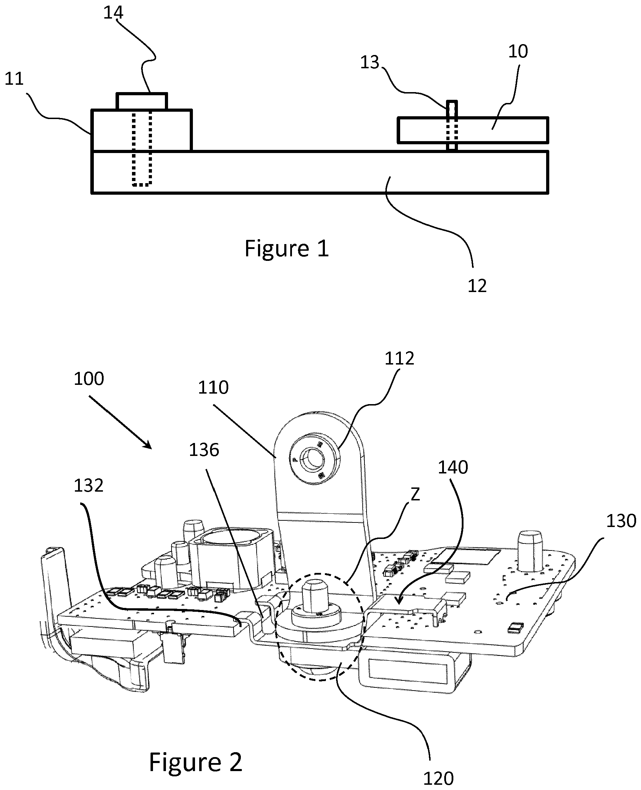

Par exemple, comme illustré en figure 1, il est connu d'alimenter la carte électronique 10 en la connectant directement sur la deuxième barre de connexion électrique 12 par une broche 13 issue de la deuxième barre de connexion électrique 12. La première barre de connexion électrique 11 est connectée à un autre point de la deuxième barre de connexion électrique 12 par une vis 14. Il faut donc prévoir une connexion de la première 11 et de la deuxième 12 barres de connexion électrique et une autre connexion entre la carte électronique 10 et la deuxième barre de connexion électrique 11. En outre, des déformations de la deuxième barre de connexion électrique 12 par rapport à la carte électronique 10 peuvent entraîner des efforts sur la carte 10, voire un endommagement de la broche 13, qui peuvent pénaliser l'alimentation électrique de la carte électronique 10. Le document EP 1376839 A1 décrit un tel agencement de barres de connexion électrique autour d'une carte électronique.

Il est donc recherché un moyen pour réaliser la connexion électrique d'une carte électronique de manière simple et sécurisée pour la carte électronique.

### PRESENTATION GENERALE DE L'INVENTION

A cet effet, l'invention concerne un ensemble électrique conforme à l'objet de la revendication 1..

Grâce à la pièce de conduction électrique, le contact électrique avec la carte électronique est réalisé à partir de la zone de connexion entre la première et la deuxième barre de connexion électrique. Ainsi, il n'est pas nécessaire de prévoir un autre point de connexion sur la deuxième barre de connexion électrique pour acheminer un courant à la carte électronique depuis la deuxième barre de connexion électrique. En outre, la pièce de conduction électrique permet de limiter les efforts transmis à la carte électronique en cas de déformations de la première ou de la deuxième barre de connexion électrique par rapport à la carte.

Selon un mode réalisation, la première barre de connexion électrique, la deuxième barre de connexion électrique, et la pièce de conduction électrique sont superposées et en contact.

Selon un mode réalisation, la première et la deuxième barres de connexion électrique comprennent respectivement, dans la zone de connexion, une première ouverture et une deuxième ouverture configurées pour recevoir un organe de fixation de manière à maintenir ensemble la première et la deuxième barres de connexion électrique pour un contact électrique ; et la pièce de conduction électrique délimite une ouverture configurée pour recevoir ledit organe de fixation de manière à maintenir la pièce de conduction électrique avec les barres de connexion électrique pour un contact électrique.

Selon un mode réalisation, la pièce de conduction électrique comprend une portion plane venant en contact avec le premier ou la deuxième barre de connexion électrique, et au moins une broche de connexion électrique s'étendant depuis un bord de la portion plane et comprenant une extrémité de liaison reliée à la portion plane, au moins une portion intermédiaire et au moins une extrémité libre reliée à ladite extrémité de liaison par ladite au moins une portion intermédiaire, ladite au moins une extrémité libre étant adaptée pour être connectée électriquement à la carte électronique.

Selon un mode réalisation, la pièce de conduction électrique est d'un seul tenant.

Selon un mode réalisation, ladite pièce de conduction électrique comprend en outre des portions d'appui venant en appui sur un support.

Selon une variante, le support est formé par la carte électronique.

Selon un mode réalisation, la carte électronique comprend une ouverture traversante ou un décrochement dans lesquels passe la première barre de connexion électrique ou la deuxième barre de connexion électrique, la zone de connexion étant dans l'ouverture traversante ou le décrochement, ou en vis-à-vis de l'ouverture traversante ou du décrochement notamment suivant une direction perpendiculaire au plan de la carte électronique.

Selon un mode réalisation, la première barre de connexion électrique est destinée à être connectée à un connecteur d'alimentation électrique, la deuxième barre de connexion électrique est destinée à acheminer une énergie électrique reçue de la première barre de connexion vers un composant électrique, la carte électronique comprenant des composants destinés à contrôler un filtrage de l'énergie délivrée par la deuxième barre de connexion.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels :
- la figure 1, déjà décrite, est une vue de côté d'un ensemble électrique selon l'art antérieur,
- la figure 2 est une vue en perspective d'un exemple d'ensemble électrique selon l'invention,
- la figure 3 est une vue en coupe de l'ensemble de la figure 2,
- la figure 4 illustre un exemple de pièce de conduction électrique compris dans l'ensemble électrique de la figure 1,
- la figure 5 illustre un autre exemple d'ensemble électrique selon l'invention.

Il faut noter que les figures exposent l'invention de manière détaillée pour mettre en oeuvre l'invention, lesdites figures pouvant bien entendu servir à mieux définir l'invention le cas échéant.

### DESCRIPTION DETAILLEE DE L'INVENTION

La figure 2 montre une vue de coupe en perspective d'un exemple d'ensemble électrique 100 selon l'invention. L'ensemble 100 comprend une première barre de connexion électrique 110 et une deuxième barre de connexion électrique 120 et une carte électronique 130. La première 110 et la deuxième 120 barres de connexion électrique sont en contact électrique l'une avec l'autre, au niveau d'une zone de connexion Z.

En particulier, chaque barre de connexion électrique 110, 120 comprend au moins une barre conductrice électriquement, notamment métallique, qui comporte une première et une deuxième extrémités destinées à être connectées chacune à un composant électrique. Par exemple, chaque barre de connexion électrique 110, 120 réalise une liaison électrique entre un premier composant électrique de l'ensemble 100 et un deuxième composant électrique de l'ensemble 100. Ainsi, dans un exemple particulier, dans la zone de connexion Z, la première barre de connexion électrique 110 comprend une extrémité qui vient se connecter à une extrémité de la deuxième barre de connexion 120 pour notamment faire circuler un courant de la première 110 vers la deuxième 120 barre de connexion électrique. Plus particulièrement, une deuxième extrémité 112 de la première barre de connexion électrique 110 peut être connectée à un connecteur électrique externe de l'ensemble électrique 100, et la deuxième extrémité de la deuxième barre de connexion électrique 120 peut être connectée à une capacité de l'ensemble électrique 100.

La carte électronique 130 est à distance de la zone de connexion Z. Autrement dit, la carte électronique 130 ne vient pas directement en contact avec les portions des barres de connexion électrique 110, 120 qui réalisent un contact électrique entre la première 110 et la deuxième 120 barre de connexion électrique. Cependant, la carte électronique 130 est connectée électriquement à la zone de connexion Z par une pièce de conduction électrique 140. Ainsi, avec une seule zone de connexion électrique Z, on obtient un contact électrique entre la carte électronique 130, la première 110 et la deuxième 120 barres de connexion électriques. Grâce à la pièce de conduction électrique 140, le contact électrique avec la carte électronique 130 est réalisé à partir de la zone de connexion Z entre la première 110 et la deuxième 120 barres de connexion électrique. Cela permet de réaliser la connexion électrique en une seule opération. En outre, la pièce de conduction électrique 140 permet de limiter une transmission des efforts dus aux déformations des barres de conduction électrique 110, 120 vers la carte électronique 130. Ainsi, un endommagement de la carte électronique 130 est évité.

En particulier, la première barre de connexion électrique 110, la deuxième barre de connexion électrique 120, et la pièce de conduction électrique 140 peuvent être superposées et en contact, de manière à assurer une connexion électrique entre les trois éléments 110, 120, 140. La première barre de connexion électrique 110, la deuxième barre de connexion électrique 120, et la pièce de conduction électrique 140 peuvent donc être empilées l'une sur l'autre, par exemple comme illustré sur les figures.

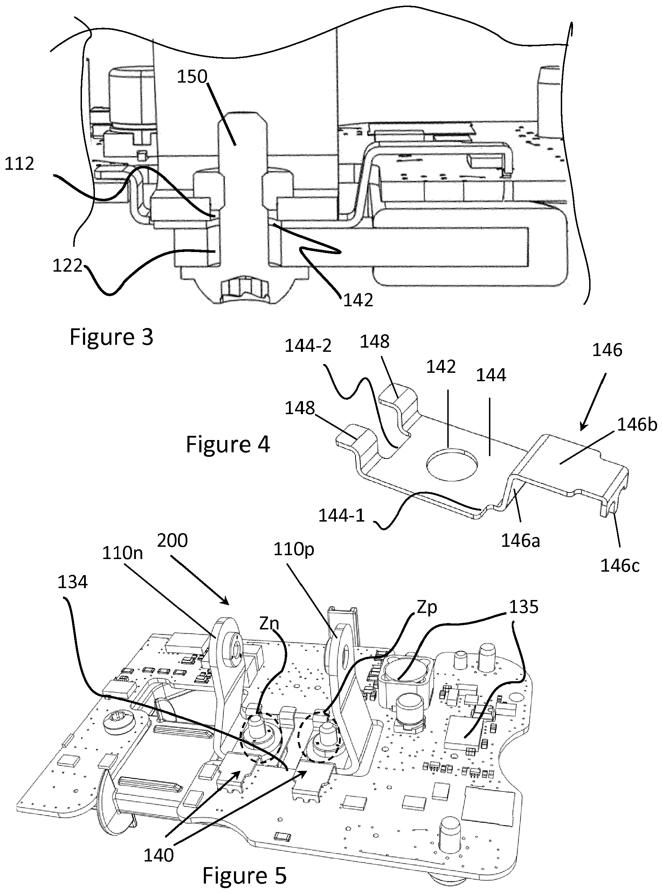

Notamment, en faisant référence à la figure 3 qui présente une vue en coupe agrandie de l'ensemble de la figure 2, la première barre de connexion électrique 110 peut comprendre une première ouverture 112 et la deuxième barre de connexion électrique 120 peut comprendre une deuxième ouverture 122. La pièce de conduction 140 comprend une troisième ouverture 142. Un organe de fixation 150, tel qu'une vis, est introduit dans ces ouvertures 112, 122, 142 de manière à réaliser un contact électrique en maintenant ensemble la première 110 et la deuxième 120 barres de connexion électrique et la pièce de conduction électrique 140. Alternativement, les barres de connexion électrique 110, 120 et la pièce de conduction électrique 140 peuvent être connectées par soudure, par brasage ou par tout autre moyen permettant de maintenir ensemble des portions des barres de conduction électrique 110, 120 et de la pièce de conduction électrique 140 pour réaliser une connexion électrique entre les trois éléments 110, 120, 140.

Comme illustré en figure 4, la pièce de conduction électrique 140 peut comprendre une portion plane 144 qui vient en contact avec la première barre de connexion électrique 110 ou la deuxième barre de connexion électrique 120. Dans les exemples illustrés sur les figures 2, 3 et 5, une face de la portion plane 144 vient contre une portion plane de la première barre de connexion électrique 110 et une face opposée de la portion plane 144 vient contre une portion plane de la deuxième barre de connexion électrique 120. Cependant, ladite portion plane 144 de la pièce de conduction électrique 140 pourrait être située à une extrémité de l'empilement. Notamment, la portion plane 144 peut comprendre la troisième ouverture 142 de la pièce de conduction électrique 140. La portion plane 144 peut être sensiblement rectangulaire, par exemple comme illustré sur les figures.

Une broche 146 de connexion électrique s'étend depuis un bord 144-1 de la portion plane 144, appelé « bord avant » en référence à la figure 4. Ladite broche 146 comprend une extrémité de liaison 146a reliée à la portion plane 144 au niveau dudit bord avant 144-1, une portion intermédiaire 146b et une extrémité libre 146c. On notera que la broche 146 de connexion électrique pourrait comprendre plus d'une extrémité libre 146c. La broche 146 permet de connecter la carte électronique 130 à la portion plane 144 et donc à la zone de connexion Z. La forme de la broche 146 de connexion électrique permet de déporter l'extrémité libre 146c de la broche 146 depuis la portion plane 144 de manière à ce qu'elle s'étende à distance de la portion plane 144. En d'autre termes, la portion intermédiaire 146b permet de franchir une distance entre la portion plane 144 et la carte électronique 130 afin notamment de positionner l'extrémité libre 146c au droit de la piste ou de la borne de connexion électrique de la carte électronique 130 au niveau de laquelle elle est connectée.

La carte électronique 130 peut comprendre une ouverture traversante 132, dans laquelle passe la première barre de connexion électrique 110 pour venir contre la deuxième barre de connexion électrique 120. La zone de connexion Z se trouve alors dans l'ouverture traversante 132, ou en vis-à-vis de l'ouverture traversante 132 suivant une direction perpendiculaire au plan de la carte électronique 130. Ceci est notamment le cas lorsque la carte électronique 130 est entre la première 110 et la deuxième 120 barres de connexion électrique pour améliorer leur intégration dans l'ensemble électrique 100.

L'extrémité de liaison 146a, la portion intermédiaire 146b et l'extrémité libre 146c de la pièce de conduction électrique 140 permettent alors de sortir de l'ouverture 132 de la carte électronique 130 dans lequel se trouve la zone de contact Z. Par exemple, l'extrémité de liaison 146a s'étend principalement dans un plan transversal par rapport à la portion plane 144. La portion intermédiaire 146b s'étend principalement dans un plan parallèle à la portion plane 144. La portion intermédiaire 146b est en partie courbée afin de relier l'extrémité de liaison 146a et l'extrémité libre 146c. L'extrémité libre 146c s'étend orthogonalement à la portion plane 144. En particulier, l'extrémité libre 146c peut présenter une forme adaptée pour être logée dans un orifice de la carte électronique 130 afin d'y être soudée. Alternativement, le bout de l'extrémité libre 146c pourrait être configuré pour venir se poser en surface de la carte électronique 130 pour y être connecté.

La portion plane 144 et la broche 146 permettent notamment d'améliorer l'intégration des composants dans un boîtier de l'ensemble électrique 100 et d'assurer à la fois une flexibilité lors du montage de la pièce de conduction électrique 140 avec la carte électronique 130, et un bon contact électrique entre l'extrémité libre 146c et son point de connexion électrique sur la carte électronique 130.

La carte électronique 130 peut faciliter le montage de la pièce de conduction électrique 140 en servant de support à la pièce de conduction électrique 140 lors de son montage dans la zone de conduction Z. A cet effet, la pièce de conduction électrique 140 peut comprendre deux pattes de maintien 148 recourbées et s'étendant depuis le bord arrière 144-2, opposé au bord avant 144-1 de la portion plane 144. Les pattes de maintien 148 viennent en appui sur un bord de l'ouverture 132 de la carte électronique 130 pour faciliter le positionnement de la pièce de conduction électrique 140. Ainsi, on évite l'utilisation d'un support supplémentaire pour la pièce de conduction électrique 140. Alternativement, un tel support, différent de la carte électronique 130, peut être utilisé.

La carte électronique 130, ou le support additionnel le cas échéant, peut comprendre un ergot de blocage 136 s'étendant du bord de l'ouverture 132 de la carte électronique 130 pour venir entre les deux pattes de maintien 148 pour permettre de bloquer en rotation la pièce de conduction électrique 140.

Par exemple, la broche 146 de connexion électrique, et les pattes de maintien 148 sont issues de matière de la portion plane 144, c'est-à-dire que la pièce 140 est réalisée d'un seul tenant. Elles peuvent ainsi avantageusement être formées en les conformant à partir d'un même matériau, notamment d'une seule feuille. Ainsi, la pièce de conduction électrique 140 peut être formée à partir d'une feuille en matériau conducteur électrique, par exemple un métal, qui est découpée et emboutie. La pièce de conduction électrique 140 est par exemple métallique et peut par être réalisée en cuivre, en acier, en aluminium ou tout autre matériau conducteur. La pièce de conduction électrique 140 peut avantageusement être recouverte d'une surface anti-usure, par exemple composée d'étain et de nickel. De manière avantageuse, l'épaisseur de la pièce de conduction électrique 140, notamment de la portion plane 144, est inférieure à 1,5 mm, de préférence de l'ordre de 1 mm, afin notamment de rendre aisée la formation de la broche de connexion électrique 146 et des pattes de maintien 148 lors de la fabrication de la pièce de conduction électrique 140.

L'ensemble électrique selon l'invention peut comprendre une pluralité de zones de connexion électrique Z avec chacune une première et une deuxième barre de connexion électrique et une pièce de conduction électrique respectives. Par exemple en figure 5, l'exemple d'ensemble électrique 200 comprend une première zone de connexion Zn ayant une polarité négative et une deuxième zone de connexion Zp ayant une polarité positive. Ces zones de connexion électriques Zn, Zp sont connectées à la carte électronique 130 par l'intermédiaire d'une pièce de conduction électrique 140 respective. En outre, l'ensemble 200 comprend un décrochement 134 au lieu d'une ouverture faite dans la carte électronique 130. Cependant, la carte électronique 130 de l'ensemble 200 pourrait comprendre une ouverture traversante dont les bords sont intégralement formés par la matière de la carte électronique 130.

En particulier, dans cet exemple, les premières barres de connexion électrique 110n, 110p peuvent être destinées à être connectées à un connecteur électrique de l'ensemble électrique 200. Un tel connecteur électrique achemine par exemple une énergie électrique délivrée par une batterie vers l'ensemble électrique 200. Les deuxièmes barres de connexion situées sous la carte électronique 130 en figure 5, peuvent être destinées à acheminer l'énergie électrique reçue des premières barres de connexion 110n , 110p vers un composant électrique de l'ensemble électrique 200. Un tel composant électrique peut être une capacité de lissage de l'ensemble électrique 200. La carte électronique 130 peut être destinée à réaliser un filtrage de l'énergie délivrée par la deuxième barre de connexion électrique 120, et comprendre des composants 135 à cet effet. L'ensemble électrique 200 est par ailleurs similaire à l'ensemble 100 illustré sur les autres figures.

L'ensemble électrique 200 forme par exemple un onduleur destiné à alimenter une machine électrique entraînant un véhicule. Alternativement l'ensemble électrique 200 peut être un chargeur électrique configuré pour être embarqué dans un véhicule afin de recharger une batterie du véhicule depuis un réseau électrique, par exemple un réseau électrique extérieur au véhicule. L'ensemble électrique 200 pourrait aussi être un convertisseur continu-continu destiné à convertir une tension entre une batterie haute tension d'un véhicule et une batterie basse tension du véhicule.

## Revendications

1. Ensemble électrique comprenant :
- une première barre de connexion électrique (110),
- une deuxième barre de connexion électrique (120), et
- une carte électronique (130),
la première et la deuxième barre de connexion électrique (110, 120) étant en contact électrique l'une avec l'autre, au niveau d'une zone de connexion (Z), ladite carte étant à distance de ladite zone de connexion (Z)
ensemble comprenant en outre une pièce de conduction électrique (140) qui réalise une liaison électrique entre ladite zone de connexion (Z) et la carte électronique (130),
et dans lequel la pièce de conduction électrique (140) est entre la première barre de connexion (110) et la deuxième barre de connexion électrique (120), et réalise la seule connexion électrique pour acheminer un courant à la carte électronique (130).

2. Ensemble électrique selon la revendication 1, dans lequel la première barre de connexion électrique (110), la deuxième barre de connexion électrique (120), et la pièce de conduction électrique (140) sont superposées et en contact.

3. Ensemble selon l'une des revendications précédentes, dans lequel la première et la deuxième barres de connexion électrique (110, 120) comprennent respectivement, dans la zone de connexion (Z), une première ouverture (112) et une deuxième ouverture (122) configurées pour recevoir un organe de fixation (150) de manière à maintenir ensemble la première et la deuxième barres de connexion électrique (110, 120) pour un contact électrique, et dans lequel
- la pièce de conduction électrique (140) délimite une ouverture (142) configurée pour recevoir ledit organe de fixation (150) de manière à maintenir la pièce de conduction électrique (140) avec les barres de connexion électrique (110, 120) pour un contact électrique.

4. Ensemble selon l'une des revendications précédentes, dans lequel la pièce de conduction électrique (140) comprend :
- une portion plane (144) venant en contact avec la première (110) ou la deuxième (120) barre de connexion électrique, et
- au moins une broche (146) de connexion électrique s'étendant depuis un bord (144-1) de la portion plane (144) et comprenant une extrémité de liaison (146a) reliée à la portion plane (144), au moins une portion intermédiaire (146b) et au moins une extrémité libre (146c) reliée à ladite extrémité de liaison (146a) par ladite au moins une portion intermédiaire (146b), ladite au moins une extrémité libre (146c) étant adaptée pour être connectée électriquement à la carte électronique (130).

5. Ensemble selon l'une des revendications précédentes, dans lequel la pièce de conduction électrique (140) est d'un seul tenant.

6. Ensemble selon l'une des revendications précédentes, dans lequel ladite pièce de conduction électrique (140) comprend en outre des portions d'appui (148) venant en appui sur un support.

7. Ensemble selon la revendication précédente, dans lequel le support est formé par la carte électronique (130).

8. Ensemble selon l'une des revendications précédentes, dans lequel la carte électronique (130) comprend une ouverture traversante (132) ou un décrochement (134) dans lesquels passe la première barre de connexion électrique (110) ou la deuxième barre de connexion électrique (120), la zone de connexion (Z) étant dans l'ouverture traversante (132) ou le décrochement (134), ou en vis-à-vis de l'ouverture traversante (132) ou du décrochement (134) notamment suivant une direction perpendiculaire au plan de la carte électronique (130).

9. Ensemble selon l'une des revendications précédentes, dans lequel la première barre de connexion électrique (110) est destinée à être connectée à un connecteur d'alimentation électrique, la deuxième barre de connexion électrique (120) est destinée à acheminer une énergie électrique reçue de la première barre de connexion (110) vers un composant électrique, la carte électronique (130) comprenant des composants (135) destinés à contrôler un filtrage de l'énergie délivrée par la deuxième barre de connexion (120).

## Patentansprüche

1. Elektrische Einheit, umfassend:
- eine erste elektrische Anschlussleiste (110),
- eine zweite elektrische Anschlussleiste (120) und
- eine Leiterplatte (130),
wobei die erste und die zweite elektrische Anschlussleiste (110, 120) an einem Anschlussbereich (Z) in elektrischem Kontakt miteinander sind, wobei die Leiterplatte von dem Anschlussbereich (Z) beabstandet ist wobei die Einheit ferner ein elektrisch leitendes Teil (140) umfasst, das eine elektrische Verbindung zwischen dem Anschlussbereich (Z) und der Leiterplatte (130) herstellt,
und wobei das elektrisch leitende Teil (140) zwischen der ersten Anschlussleiste (110) und der zweiten elektrischen Anschlussleiste (120) ist und den einzigen elektrischen Anschluss herstellt, um einen Strom zu der Leiterplatte (130) zu leiten.

2. Elektrische Einheit nach Anspruch 1, wobei die erste elektrische Anschlussleiste (110), die zweite elektrische Anschlussleiste (120) und das elektrisch leitende Teil (140) übereinander liegen und in Kontakt sind.

3. Einheit nach einem der vorhergehenden Ansprüche, wobei die erste und die zweite elektrische Anschlussleiste (110, 120), in dem Anschlussbereich (Z), eine erste Öffnung (112) beziehungsweise eine zweite Öffnung (122) umfassen, die dazu ausgestaltet sind, ein Befestigungsorgan (150) aufzunehmen, so dass die erste und die zweite elektrische Anschlussleiste (110, 120) für einen elektrischen Kontakt zusammengehalten werden, und wobei
- das elektrisch leitende Teil (140) eine Öffnung (142) begrenzt, die dazu ausgestaltet ist, das Befestigungsorgan (150) aufzunehmen, so dass das elektrisch leitende Teil (140) mit den elektrischen Anschlussleisten (110, 120) für einen elektrischen Kontakt gehalten wird.

4. Einheit nach einem der vorhergehenden Ansprüche, wobei das elektrisch leitende Teil (140) umfasst:
- einen ebenen Abschnitt (144), der in Kontakt mit der ersten (110) oder der zweiten (120) elektrischen Anschlussleiste gelangt, und
- mindestens einen elektrischen Anschlussstift (146), der sich von einem Rand (144-1) des ebenen Abschnitts (144) aus erstreckt und ein mit dem ebenen Abschnitt (144) verbundenes Verbindungsende (146a), mindestens einen Zwischenabschnitt (146b) und mindestens ein freies Ende (146c) umfasst, das über den mindestens einen Zwischenabschnitt (146b) mit dem Verbindungsende (146a) verbunden ist, wobei das mindestens eine freie Ende (146c) geeignet ist, elektrisch an die Leiterplatte (130) angeschlossen zu werden.

5. Einheit nach einem der vorhergehenden Ansprüche, wobei das elektrisch leitende Teil (140) einstückig ist.

6. Einheit nach einem der vorhergehenden Ansprüche, wobei das elektrisch leitende Teil (140) ferner Auflageabschnitte (148) umfasst, die auf einem Träger aufliegen.

7. Einheit nach dem vorhergehenden Anspruch, wobei der Träger durch die Leiterplatte (130) gebildet wird.

8. Einheit nach einem der vorhergehenden Ansprüche, wobei die Leiterplatte (130) eine durchgehende Öffnung (132) oder eine Ausklinkung (134) umfasst, in denen die erste elektrische Anschlussleiste (110) oder die zweite elektrische Anschlussleiste (120) verläuft, wobei der Anschlussbereich (Z) in der durchgehenden Öffnung (132) oder der Ausklinkung (134) oder gegenüber der durchgehenden Öffnung (132) oder der Ausklinkung (134) ist, insbesondere entlang einer senkrecht zur Ebene der Leiterplatte (130) verlaufenden Richtung.

9. Einheit nach einem der vorhergehenden Ansprüche, wobei die erste elektrische Anschlussleiste (110) dazu bestimmt ist, an einen Steckverbinder zur elektrischen Versorgung angeschlossen zu werden, die zweite elektrische Anschlussleiste (120) dazu bestimmt ist, eine von der ersten Anschlussleiste (110) erhaltene elektrische Energie zu einem elektrischen Bauelement zu führen, wobei die Leiterplatte (130) Bauelemente (135) umfasst, die dazu bestimmt sind, ein Filtern der von der zweiten Anschlussleiste (120) abgegebenen elektrischen Energie zu kontrollieren.

## Claims

1. Electrical assembly comprising:
- a first busbar (110),
- a second busbar (120), and
- an electronic board (130),
the first and the second busbar (110, 120) being in electrical contact with one another, in the connection area (Z), said board being at a distance from said connection area (Z),
the assembly further comprising an electrical conduction part (140) which makes an electrical connection between said connection area (Z) and the electronic board (130), and wherein the electrical conduction part (140) is between the first busbar (110) and the second busbar (120), and provides the only electrical connection for supplying a current to the electronic board (130).

2. Electrical assembly according to Claim 1, wherein the first busbar (110), the second busbar (120) and the electrical conduction part (140) are superposed and in contact.

3. Assembly according to one of the preceding claims, wherein the first and the second busbar (110, 120) comprise, in the connection area (Z), a first hole (112) and a second hole (122), respectively, which are configured to receive a fastening member (150) so as to hold the first and the second busbar (110, 120) together for electrical contact, and wherein
- the electrical conduction part (140) delimits a hole (142) configured to receive said fastening member (150) so as to hold the electrical conduction part (140) with the busbars (110, 120) for electrical contact.

4. Assembly according to one of the preceding claims, wherein the electrical conduction part (140) comprises:
- a planar portion (144) coming into contact with the first busbar (110) or the second busbar (120), and
- at least one electrical connection pin (146) extending from an edge (144-1) of the planar portion (144) and comprising a connecting end (146a) connected to the planar portion (144), at least one intermediate portion (146b) and at least one free end (146c) connected to said connecting end (146a) by said at least one intermediate portion (146b), said at least one free end (146c) being suitable for being electrically connected to the electronic board (130).

5. Assembly according to one of the preceding claims, wherein the electrical conduction part (140) is in one piece.

6. Assembly according to one of the preceding claims, wherein said electrical conduction part (140) further comprises bearing portions (148) bearing on a support.

7. Assembly according to the preceding claim, wherein the support is formed by the electronic board (130).

8. Assembly according to one of the preceding claims, wherein the electronic board (130) comprises a through-hole (132) or a recess (134) through which the first busbar (110) or the second busbar (120) passes, the connection area (Z) being in the through-hole (132) or the recess (134), or opposite the through-hole (132) or the recess (134), notably in a direction perpendicular to the plane of the electronic board (130).

9. Assembly according to one of the preceding claims, wherein the first busbar (110) is intended to be connected to an electrical power connector, the second busbar (120) is intended to carry electrical energy received from the first busbar (110) to an electrical component, the electronic board (130) comprising components (135) intended to control filtering of the energy delivered by the second busbar (120).
